# FASCICULE DE BREVET EUROPEEN

(11) **EP 3 055 440 B1**
(45) Date de publication et mention de la délivrance du brevet: **11.03.2020**
(21) Numéro de dépôt: 13773327.5
(22) Date de dépôt: 01.08.2013
(51) Int. Cl.: C23C 14/16, C23C 14/56, C23C 28/00, C23C 14/24, C25D 13/02, C23C 14/58

(54) **TÔLE D'ACIER PEINTE MUNIE D'UN REVÊTEMENT DE ZINC**
LACKIERTES STAHLBLECH, VERSEHEN MIT EINEM ZINKÜBERZUG
PAINTED STEEL SHEET PROVIDED WITH A ZINC COATING

(43) Date de publication de la demande: 17.08.2016
(73) Titulaire: Arcelormittal, 1160 Luxembourg (LU)
(72) Inventeur: CHALEIX, Daniel, F-57420 Verny (FR); JACQUES, Daniel, F-57100 Thionville (FR); SILBERBERG, Eric, Haltinne (Gesves) (BE); PACE, Sergio, B-1370 Jodoigne (BE); SCHMITZ, Bruno, B-4550 Nandrin (BE); VANDEN EYNDE, Xavier, B-4261 Latinne (Braives) (BE)
(74) Mandataire: Lavoix
(86) Numéro de dépôt international: PCT/IB2013/001682
(87) Numéro de publication internationale: WO 2015/015238

(56) Documents cités:
- EP-A1- 0 630 987
- SCHMITZ B ET AL: ""Jet Vapor Deposition", a novel vacuum coating technique with superior properties / JVD : un nouveau procédé de revêtement sous vide pour des produits à propriétés améliorées", REVUE DE MÉTALLURGIE - CAHIERS D'INFORMATIONS TECHNIQUES, vol. 97, no. 7/8, juillet 2000 (2000-07), pages 971-978, XP000976084, Revue de Métallurgie, Paris [FR] ISSN: 0035-1563

## Description

La présente invention est relative à une tôle d'acier munie d'un revêtement comprenant une couche de zinc recouverte de peinture, qui est plus particulièrement destinée à la fabrication des pièces pour l'automobile, sans pour autant y être limitée.

Les revêtements galvanisés comprenant essentiellement du zinc sont traditionnellement utilisés pour leur bonne protection contre la corrosion, que ce soit dans le secteur automobile ou dans la construction, par exemple.

Dans la suite du texte on entendra par revêtement de zinc un revêtement de zinc pur, éventuellement constitué d'impuretés inévitables lors de la production et présentes en quantité de traces.

Les tôles ainsi revêtues peuvent ensuite être découpées puis mises en forme, par exemple par emboutissage, pliage ou profilage, pour former une pièce que l'on peut ensuite mettre en peinture pour former, sur le revêtement, un film de peinture. Ce film de peinture est généralement réalisé par cataphorèse.

Les procédés les plus utilisés pour réaliser le dépôt d'un revêtement de zinc sur la surface d'une tôle d'acier sont la galvanisation ou l'électrozingage. Mais ces procédés classiques ne permettent pas de revêtir des nuances d'aciers riches en éléments oxydables tels que Si, Mn, AI, P, Cr ou B, ce qui a conduit à développer de nouveaux procédés de revêtements, et notamment des technologies de dépôt sous vide telle que le dépôt sous vide par jet de vapeur sonique(JVD).

Cependant, les surfaces des tôles revêtues selon ces procédés de dépôt sous vide présentent suite à l'étape de peinture par cataphorèse des défauts de surface qui altèrent l'aspect esthétique des pièces formées.

Le but de la présente invention est donc de remédier aux inconvénients des aciers revêtus de l'art antérieur en mettant à disposition une tôle d'acier revêtue de zinc par dépôt sous vide et d'une couche de peinture présentant un bon aspect de surface.

Le demande de brevet EP0630987 divulgue une tôle d'acier galvanisée-alliée comprenant deux couches :
- une couche de base constituée de zinc ou alliage de zinc et
- une couche de surface étant constituée d'un alliage fer-zinc.

Pour résoudre le problème de défauts de surface, EP0630987 enseigne l'ajout d'une couche de revêtement de surface en alliage fer-zinc ayant une teneur pondérale en fer inférieure à 60% sur une couche de base constituée de zinc ou alliage de zinc avant la mise en peinture.

La publication scientifique « Jet Vapor Déposition, a novel vaccum coating technique with superior properties » publiée dans la revue de Métallurgie CIT en Juillet-Aout 2000 décrit seulement des modèles mathématiques pour estimer la trajectoire de vapeur métallique et calculer l'efficacité totale métallique par dépôt JVD de Zn, Zn-Mg et Al.

A cet effet, l'invention a pour premier objet une tôle d'acier selon la revendication 1.

La tôle peut également comprendre les caractéristiques des revendications 2 à 5 prises isolément ou en combinaison.

L'invention a également pour objet un procédé selon la revendication 6.

Le procédé peut également comprendre les caractéristiques des revendications 7 à 8, prises isolément ou en combinaison.

D'autres caractéristiques et avantages de l'invention apparaitront à la lecture de la description qui va suivre.

Afin d'illustrer l'invention, des essais ont été réalisés et vont être décrits à titre d'exemples non limitatifs, notamment en référence aux figures qui représentent :
- La figure 1 représente une installation de dépôt JVD permettant de mettre en œuvre le procédé selon l'invention
- La figure 2 est une photographie grossissement x4 d'une tôle revêtue selon l'art antérieur.
- La figure 3 est une photographie grossissement x4 d'une tôle revêtue selon l'invention.

La tôle revêtue selon l'invention comprend tout d'abord un substrat en acier, de préférence laminé à chaud puis laminé à froid pour pouvoir être utilisée pour la fabrication de pièces de carrosserie pour l'automobile. L'invention n'est pas pour autant limitée à ce domaine et peut trouver un emploi pour toute pièce en acier quel que soit son usage final.

Le substrat en acier peut notamment par exemple être l'une des nuances d'acier THR (Très Haute Résistance, généralement comprise entre 450 et 900 MPa) ou UHR (Ultra Haute Résistance, généralement supérieure à 900 MPa) suivantes qui sont riches en éléments oxydables:
- aciers sans éléments interstitiels (IF-Interstitial Free), qui peuvent contenir jusqu'à 0,1% en poids de Ti;
- aciers dual-phase tels que les aciers DP 500 jusqu'aux aciers DP 1200 qui peuvent contenir jusqu'à 3% en poids de Mn en association avec jusque 1% en poids de Si, Cr et/ou Al,
- aciers TRIP (TRansformation Induced Plasticity) tel que l'acier TRIP 780 qui contient par exemple environ 1,6% en poids de Mn et 1,5% en poids de Si;
- aciers TRIP ou dual-phase contenant du phosphore;
- aciers TWIP (TWining induced plasticity) - aciers ayant une forte teneur en Mn (généralement 17-25% en poids),
- aciers à basse densité tels que les aciers Fe-AI qui peuvent contenir par exemple jusqu'à 10% en poids de Al;
- aciers inoxydables, qui ont une forte teneur en chromes (généralement 13-35% en poids), en association avec d'autres éléments d'alliage (Si, Mn, Al...)

La tôle d'acier pourra éventuellement être revêtue d'une ou plusieurs couches en complément de la couche de zinc de manière adaptée aux propriétés souhaitées du produit final. La couche de zinc sera de préférence la couche supérieure du revêtement.

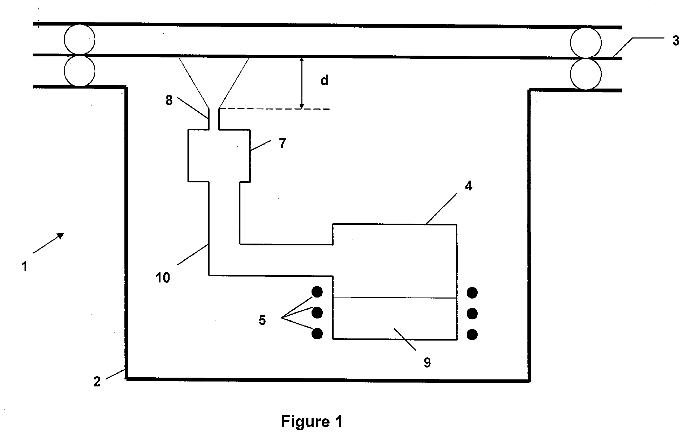

Un procédé de fabrication d'une tôle d'acier selon l'invention est représenté plus particulièrement en figure 1, sur laquelle on peut voir une installation 1 comprenant une chambre de dépôt sous vide 2. Cette chambre comprend un sas d'entrée et un sas de sortie (non représentés), entre lesquels circule la tôle d'acier 3 à revêtir. Le défilement de la tôle 3 peut se faire par tous moyens adaptés, par exemple un rouleau support rotatif sur lequel peut s'appuyer la bande.

Placée en regard de la surface de la bande à revêtir se trouve une chambre d'éjection 7 munie d'une fente 8, la partie supérieure de la fente 8 étant placée à une distance d de la surface de la bande à revêtir comprise par exemple entre 20 et 60 mm. Cette chambre 7 est montée sur un creuset d'évaporation 4 qui contient le zinc liquide 9 à déposer sur la surface de la bande d'acier 3. Le creuset d'évaporation 4 est avantageusement muni d'un dispositif de chauffage par induction 5 permettant à la vapeur de se former. La vapeur s'échappe alors du creuset par une conduite 10 qui l'amène vers la chambre d'éjection 7, et la fente 8, de préférence calibrée, de manière à former un jet dirigé vers la surface du substrat à revêtir. La présence de la fente 8 permet la régulation du débit massique de vapeur, à une vitesse sonique constante le long de la fente (col sonique), ce qui procure l'avantage d'obtenir un dépôt uniforme. On se référera par la suite à cette technique en utilisant l'acronyme " JVD " (pour Jet Vapor Déposition). Des informations additionnelles sur cette technique sont notamment décrites dans le brevet EP07447056.

Dans un autre mode de réalisation non représenté le creuset et la chambre d'éjection ne sont qu'une seule et même pièce, comprenant une fente dirigée vers la surface du substrat à revêtir. Dans ce mode de réalisation la vapeur créée par chauffage du bain de zinc remonte directement vers la fente et forme un jet dirigé vers la surface du substrat à revêtir.

La pression P_{chbre} dans la chambre de dépôt 2 est maintenue à une pression comprise entre 6.10⁻² mbar et 2.10⁻¹ mbar.

La pression P_{chbre} dans la chambre de dépôt 2 et la pression P_{eject} dans la chambre d'éjection 7 sont éventuellement maintenues de telle sorte que le ratio P_{chbre} sur P_{eject} est compris entre 2.10⁻³ et 5,5.10⁻²., ce qui permet d'améliorer la protection temporaire de ces revêtements.

Une couche d'huile est éventuellement appliquée sur la surface de la tôle ainsi revêtue afin d'assurer une protection temporaire en cas de stockage dans un milieu humide et/ou salin avant la livraison ou la transformation en produit final.

La tôle 1, ayant subie ou non une étape dite de skin-pass, peut ensuite être découpée puis mise en forme, par exemple par emboutissage, pliage ou profilage, pour former une pièce que l'on peut ensuite mettre en peinture pour former, sur le revêtement, un film de peinture .

Pour les applications automobiles, après phosphatation, on trempe chaque pièce dans un bain de cataphorèse, et on applique successivement, une couche de peinture d'apprêt, une couche de peinture de base, et éventuellement une couche de vernis de finition.

Avant d'appliquer la couche de cataphorèse sur la pièce, celle-ci est préalablement dégraissée puis phosphatée de manière à assurer l'adhérence de la cataphorèse.

La couche de cataphorèse assure à la pièce une protection complémentaire contre la corrosion. La couche de peinture d'apprêt, généralement appliquée au pistolet, prépare l'apparence finale de la pièce et la protège contre le gravillonnage et contre les UV. La couche de peinture de base confère à la pièce sa couleur et son apparence finale. La couche de vernis confère à la surface de la pièce une bonne résistance mécanique, une résistance contre les agents chimiques agressifs et un bon aspect de surface.

Généralement, le poids de la couche de phosphatation est compris entre 1,5 et 5 g/m².

Les films de peinture mis en œuvre pour protéger et garantir un aspect de surface optimal aux pièces, comprennent par exemple une couche de cataphorèse de 15 à 25 µm d'épaisseur, une couche de peinture d'apprêt de 35 à 45 µm d'épaisseur, et une couche de peinture de base de 40 à 50 µm d'épaisseur.

Dans les cas où les films de peinture comprennent en outre une couche de vernis, les épaisseurs des différentes couches de peinture sont généralement les suivantes :
- couche de cataphorèse : entre 15 et 25µm, de préférence inférieure à 20µm,
- couche de peinture d'apprêt : inférieure à 45µm,
- couche de peinture de base : inférieure à 20µm, et
- couche-de vernis : inférieure à 55 µm.

Les films de peinture pourront également ne pas comprendre de couche de cataphorèse, et ne comprendre qu'une couche de peinture d'apprêt et une couche de peinture de base et éventuellement une couche de vernis.

De préférence, l'épaisseur totale des films de peinture sera inférieure à 120 µm, voire 100 µm.

On observe parfois en surface de la tôle suite à l'application de la couche de cataphorèse des défauts de type cratère, qui, sur des tôles d'acier, sont des lieux privilégiés d'amorçage de la corrosion, et qui dégradent fortement l'aspect de surface de la tôle. Ces cratères se présentent sous la forme de trous tronconiques débouchant à la surface de la couche de cataphorèse et peuvent éventuellement traverser le revêtement jusqu'à atteindre la surface du substrat d'acier ; ils ont un diamètre généralement compris entre 100 et 500 µm à la base, entre 5 et 20 µm au sommet.

L'invention va à présent être explicitée par des essais réalisés à titre indicatif et non limitatif.

### Tests

### Critère d'acceptation

Pour évaluer la sensibilité d'un produit au risque d'apparition de défauts de type cratères il existe un critère relatif au nombre de défauts présents sur une tôle d'acier revêtue de dix centimètres sur quinze centimètres après que cette tôle ait été soumise à un polissage.

Pour que la tôle d'acier revêtue soit acceptée elle doit comportait moins de quatre défauts par plaque de 10x15cm², ce qui équivaut à moins de 2,7 défauts par décimètre carré.

### Essais

On réalise 3 séries de tôles d'acier IF laminée à froid de type DC06 tel que commercialisé par ArcelorMittal, comprenant un revêtement de zinc d'une épaisseur de 7,5 µm.

Pour les deux échantillons le revêtement a été effectué par dépôt JVD, à une pression dans la chambre de dépôt différente, avec une distance d entre la partie supérieure de la fente de la chambre d'extraction et la surface de la bande à revêtir identique égale à environ 35mm.

| Echantillon | Type de revêtement |
|---|---|
| 1 | JVD -pression < 10⁻² mbar dans la chambre de dépôt |
| 2* | JVD - pression 1,1.10⁻¹ mbar dans la chambre de dépôt * |

| | |
|---|---|
| * selon l'invention | |

Les échantillons sont ensuite revêtus d'une huile de type Quaker Ferrocoat N 6130 à 1,2 g/m² ±0,3g/m² et soumis aux étapes de phosphatation puis cataphorèse. Un dispositif de capture et traitement d'images tel que le dispositif commercial TalySurf CLI 2000 permet ensuite de calculer le nombre de défauts de type cratères tels que définis précédemment présent en surface de la bande revêtue. Ces cratères se présentent sous la forme de trous tronconiques débouchant à la surface de la couche de cataphorèse et peuvent éventuellement traverser le revêtement jusqu'à atteindre la surface du substrat d'acier

| Echantillon | Nombre de défauts |
|---|---|
| 1 | >>> 2,7dm² (jusqu'à 1600/dm²) |
| 2* | < 2,7/dm² |

L'échantillon 2 selon l'invention remplit donc le critère d'acceptabilité contrairement à l'échantillon n°1.

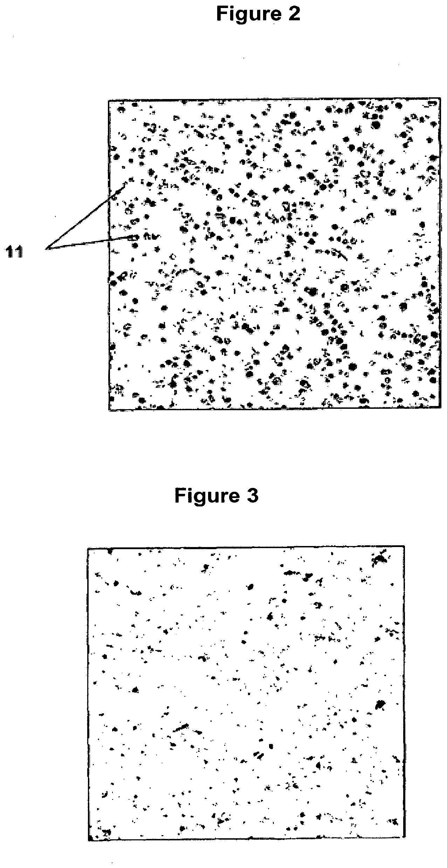

La figure 2 est une photographie à l'échelle x4 d'une tôle d'acier selon l'art antérieur sur laquelle a été appliquée une couche de peinture par un procédé de cataphorèse. Cette tôle d'acier IF laminée à froid de type DC06 a été revêtue de 7,5µm de Zn, par un procédé JVD dans lequel la pression dans la chambre dépôt était maintenue à une pression inférieure à 10⁻² mbar, la distance d étant égale à 35mm. La tôle ainsi revêtue a été recouverte d'une couche d'huile de type Quaker Ferrocoat N 6130 à 1,2 g/m² ±0,3g/m² afin d'assurer la protection temporaire de la surface, puis a subi ensuite une étape de peinture par cataphorèse. On observe sur cette tôle la présence de défauts de type cratères 11 tels que définis précédemment. Ces défauts dégradent fortement l'aspect de surface de la tôle.

La figure 3 est une photographie à l'échelle x4 d'une tôle d'acier selon l'invention. Cette tôle d'acier IF laminée à froid de type DC06 a été revêtue de 7.5µm de Zn, par un procédé JVD dans lequel la pression dans la chambre de dépôt était maintenue à 1,1.10⁻¹mbar et la distance d étant égale à 35mm. La tôle ainsi revêtue a été recouverte d'une couche d'huile de type Quaker Ferrocoat N 6130 à 1,2 g/m² ±0,3g/m² afin d'assurer la protection temporaire de la surface, puis a subi ensuite une étape de peinture par cataphorèse. On observe l'absence de défaut de types cratères en surface de cette tôle d'acier. Les nuances de gris apparaissant sur la figure sont liées à la rugosité de la surface de la tôle d'acier et ne sont pas liées à des défauts dans le sens exprimé précédemment.

Les mêmes résultats peuvent être observés avec l'utilisation d'une huile Fuchs Anticorit RP 4107s à 1,2g/m² à la place de la Quaker Ferrocoat.

Par ailleurs les inventeurs ont noté que le changement de pression à l'intérieur de la chambre de dépôt n'affecte pas la vitesse de dépôt du revêtement sur la surface de la tôle d'acier

## Revendications

1. Tôle d'acier munie d'un revêtement comprenant au moins une couche de zinc pur, éventuellement constituée d'impuretés inévitables lors de la production et présentes en quantité de traces, et une couche supérieure de peinture réalisée par cataphorèse, la couche de zinc étant la couche supérieure de revêtement avant l'application de la couche de peinture et étant réalisée par un procédé de dépôt sous vide par jet de vapeur sonique dans une chambre de dépôt maintenue à une pression P_{chbre} comprise entre 6.10⁻² mbar et 2.10⁻¹ mbar.

2. Tôle d'acier selon la revendication 1 obtenue par un procédé selon lequel le ratio entre la pression à l'intérieur de la chambre de dépôt P_{chbre} et la pression à l'intérieur de chambre d'éjection du zinc P_{eject} est compris entre 2.10⁻³ et 5,5.10⁻².

3. Tôle d'acier selon la revendication 1 ou 2 obtenue par un procédé selon lequel la distance d entre la partie supérieure de la fente 8 de la chambre d'extraction 7 et la tôle d'acier à revêtir est comprise entre 20 et 60 mm.

4. Tôle d'acier selon l'une quelconque des revendications 1 à 3 dont la surface de ladite tôle ne comprend pas plus de 2,7 défauts de type cratère par décimètre carré.

5. Tôle d'acier selon l'une quelconque des revendications précédentes dans laquelle l'acier revêtu est un acier à Très Haute Résistance.

6. Procédé de fabrication d'une tôle revêtue et peinte qui comprend le revêtement de ladite tôle par un jet de vapeur sonique de zinc pur, éventuellement constitué d'impuretés inévitables lors de la production et présentes en quantité de traces, à l'intérieur d'une chambre de dépôt maintenue à une pression P_{chbre} comprise entre 6.10⁻² mbar et 2.10⁻¹ mbar.

7. Procédé de fabrication selon la revendication 6 selon lequel le ratio entre la pression P_{chbre} au sein de la chambre de dépôt et la pression P_{eject} au sein de la chambre d'éjection est compris entre 2.10⁻³ et 5,5.10⁻².

8. Procédé de fabrication selon la revendication 6 dans lequel la distance d entre la partie supérieure de la fente 8 de la chambre d'éjection 7 et la tôle d'acier à revêtir est comprise entre 20 et 60 mm.

## Patentansprüche

1. Stahlblech, das mit einer Beschichtung versehen ist, die aufweist wenigstens eine Schicht aus reinem Zink, eventuell mit unvermeidbaren Verunreinigungen aus der Erstellung gebildet, die in der Menge von Spuren vorliegen, und eine obere Farb-Schicht, die via Kataphorese erstellt ist, wobei die Schicht aus Zink die obere Beschichtungsschicht ist vor der Aufbringung der Farb-Schicht und erstellt wird durch ein Vakuumabscheideverfahren via Schalldampfstrahl in einer Abscheidekammer, die bei einem Druck P_{chbre} gehalten ist, der zwischen 6.10⁻² mbar und 2.10⁻¹ mbar beträgt.

2. Stahlblech gemäß Anspruch 1, erhalten durch ein Verfahren, bei welchem das Verhältnis zwischen dem Druck im Innern der Abscheidekammer P_{chbre} und dem Druck im Inneren der Ausstoßkammer des Zink P_{eject} zwischen 2.10⁻³ und 5,5.10⁻² beträgt.

3. Stahlblech gemäß Anspruch 1 oder 2, erhalten durch eine Verfahren, bei dem der Abstand d zwischen dem oberen Abschnitt des Spalts 8 der Austragskammer 7 und dem zu beschichtenden Stahlblech zwischen 20 und 60 mm beträgt.

4. Stahlblech gemäß irgendeinem der Ansprüche 1 bis 3, wobei die Oberfläche des besagten Blechs nicht mehr als 2,7 Fehlstellen des Kratertyps pro Quadratdezimeter hat.

5. Stahlblech gemäß irgendeinem der vorhergehenden Ansprüche, wobei der beschichtete Stahl ein ultra-hochfester Stahl ist.

6. Verfahren zum Herstellen eines beschichteten und lackierten Blechs, welches aufweist Beschichten des besagten Blechs mittels eines Schalldampfstrahls aus reinem Zink, der eventuell mit unvermeidbaren Verunreinigungen aus der Herstellung ausgebildet ist, die in der Menge von Spuren vorliegen, im Inneren einer Abscheidekammer, die bei einem Druck P_{chbre} gehalten wird, der zwischen 6.10⁻² mbar und 2.10⁻¹ mbar beträgt.

7. Verfahren zum Herstellen gemäß Anspruch 6, wobei das Verhältnis zwischen dem Druck P_{chbre} in der Abscheidekammer und dem Druck P_{eject} in der Ausstoßkammer zwischen 2.10⁻³ und 5,5.10⁻² beträgt.

8. Verfahren zum Herstellen gemäß Anspruch 6, wobei der Abstand d zwischen dem oberen Abschnitt des Spalts 8 der Ausstoßkammer 7 und dem zu beschichtenden Stahlblech zwischen 20 und 60 mm beträgt.

## Claims

1. Steel sheet provided with a coating comprising at least one layer of pure zinc, optionally including impurities which are unavoidable during production and are present in trace amounts, and a top layer of paint produced by cataphoresis, the layer of zinc being the top coating layer before application of the layer of paint and being produced by a method of jet vapour deposition in a deposition chamber maintained at a pressure P_{chbre} of between 6.10⁻² mbar and 2.10⁻¹ mbar.

2. Steel sheet according to claim 1 obtained by a method in which the ratio between the pressure inside the deposition chamber P_{chbre} and the pressure inside the zinc ejection chamber P_{eject} is between 2.10⁻³ and 5.5.10⁻².

3. Steel sheet according to claim 1 or 2 obtained by a method in which the distance d between the upper portion of the slot 8 of the extraction chamber 7 and the steel sheet to be coated is between 20 and 60 mm.

4. Steel sheet according to any one of claims 1 to 3, in which the surface of said sheet does not contain more than 2.7 crater-type defects per square decimetre.

5. Steel sheet according to any one of the preceding claims, wherein the coated steel is a very high strength steel.

6. Method for manufacturing a coated and painted sheet, which comprises coating said sheet by means of a sonic vapour jet of pure zinc, optionally including impurities which are unavoidable during production and are present in trace amounts, inside a deposition chamber maintained at a pressure P_{chbre} between 6·10⁻² mbar and 2·10⁻¹ mbar.

7. Manufacturing method according to claim 6, wherein the ratio between the pressure P_{chbre} inside the deposition chamber and the pressure P_{eject} inside the ejection chamber is between 2·10⁻³ and 5·5_{·}10⁻².

8. Manufacturing method according to claim 6, wherein the distance d between the upper portion of the slot 8 of the ejection chamber 7 and the steel sheet to be coated is between 20 and 60 mm.
